# EUROPEAN PATENT SPECIFICATION

(11) **EP 3 594 723 B1**
(45) Date of publication and mention of the grant of the patent: **18.11.2020**
(21) Application number: 18213254.8
(22) Date of filing: 18.12.2018
(51) Int. Cl.: G01T 1/24, H01L 31/00

(54) **DOUBLE RESPONSE IONIZING RADIATION DETECTOR AND MEASURING METHOD USING THE SAME**
IONISIERENDER DOPPELREAKTIONS-STRAHLUNGSDETEKTOR UND MESSVERFAHREN UNTER VERWENDUNG DESSELBEN
DÉTECTEUR DE RAYONNEMENT IONISANT À DOUBLE RÉPONSE ET PROCÉDÉ DE MESURE L'UTILISANT

(30) Priority: 11.07.2018 LT 2018025
(43) Date of publication of application: 15.01.2020
(73) Proprietor: Vilnius University, 01513 Vilnius (LT)
(72) Inventor: GAUBAS, Eugenijus, 06203 Vilnius (LT); CEPONIS, Tomas, 04116 Vilnius (LT); KALESINSKAS, Vidas, 14264 Vilnius (LT); PAIPULAS, Domas, 03210 Vilnius (LT); PAVASARIS, Ceslovas, 08445 Vilnius (LT)
(74) Representative: Petniunaite, Jurga

(56) References cited:
- US-A- 5 639 673
- GAUBAS E ET AL: "In situcharacterization of radiation sensors based on GaN LED structure by pulsed capacitance technique and luminescence spectroscopy", SENSORS AND ACTUATORS A: PHYSICAL, vol. 267, 10 October 2017 (2017-10-10), pages 194-199, XP085248008, ISSN: 0924-4247, DOI: 10.1016/J.SNA.2017.10.025

## Description

### Technical field

The invention relates to a field of detection and measurement of ionizing radiation.

### Background art

Semiconductor junction structures, containing metal-Schottky and p/n as well as heterojunction barriers, have been developed for detection of ionizing radiations (S. N. Ahmed "Physics and engineering of radiation detection ", Elsevier, 2007, London). Silicon and germanium-based particle and X-ray as well as gamma-ray detectors are widely used in high energy physics experiments, in medical applications, etc. (S. N. Ahmed "Physics and engineering of radiation detection ", Elsevier, 2007, London). Various technology materials and scheme-technique solutions, such as 3D sensor-arrays and pin detectors with internal amplification layers (for instance, Low Gain Avalanche Diodes (N. Moffat, et. al "Low Gain Avalanche Detectors (LGAD) for particle physics and synchrotron applications ", Journ. Instrum., 13 (2018) C03014)), are invented to enhance the detector response and to overcome degradation of sensors under radiation damage. To enhance material radiation tolerance, binary and ternary solid compounds made of heavy elements (such as GaAs, CdTe, CdZnTe), being the rather wide-bandgap semiconductors, are applied in formation of radiation-proof sensors (e.g., J. W. Murphy, et. al. "Thin film cadmium telluride charged particle sensors for large area neutron detectors ", Appl. Phys. Lett. 105 (2014) 112107; Y. Okada, et. al. "CdTe and CdZnTe detectors for timing measurements ", IEEE TRANSACTIONS ON NUCLEAR SCIENCE, (2001); A.I. Ayzenshtat, et. al. "GaAs as a material for particle detectors ", Nuclear Instruments and Methods in Physics Research A 494 (2002) 120-127; M.C. Veale, et. al., "Chromium compensated gallium arsenide detectors for X-ray and γ-ray spectroscopic imaging ", Nuclear Instruments and Methods in Physics Research A 752 (2014) 6-14).

US patent No 4,533,933 discloses a semiconductor detector comprising a plate-shaped p-type conduction semiconductor substrate, on which first of side surfaces a dielectric layer is formed, in which a hole (opening) is formed up to the first surface of a substrate - an optical window in which a metallic layer is formed on the first surface of the substrate - the Schottky junction, on a perimeter of which a metallic ohmic contact is formed with a first output terminal, on the substrate under the optical window on the perimeter of the optical window opening a n⁺-type conduction guard ring is formed, and on a second surface of the substrate an ohmic contact with a second output terminal is formed.

US patent No 5,639,673 discloses ionizing detector comprising a substrate, a radiation sensitive material and metal Schottky junctions and contact terminals for making ohmic contacts with said Schottky junctions wherein a buffer layer is formed on the top surface of the substrate where a mesa structure is formed on the top surface of the buffer layer parallel to the top surface of the substrate, where the top surface of the mesa structure comprises an irradiance area and the detector further comprises an optical fiber attached above the mesa structure.

A drawback of the prior art is that due to irradiation beam spreading on the substrate surface, spatial resolution of the detector is insufficient. Such detector should also be frozen to enhance its radiation hardness and to increase range of measurements for detection of high irradiation fluences. Moreover, it is sensitive to Solar spectrum radiation which generates additional noises and pedestals in recorded current signals. Another shortcoming is that there is no possibility of recording an optical response at room temperature ambient as well as luminescence spectrum intensity distribution and transients. Other disadvantage is that the Schottky junction significantly limits the choice of detector's active area material. There is also a drawback that the Schottky junction dark current is relatively large and therefore has a relatively low breakdown voltage. Other disadvantage is that the Schottky junction is sensitive to density of radiation induced (inevitable) defects which distort signals and require permanent re-calibration of the recorded characteristics.

The present invention is dedicated to overcoming of the above shortcomings and for producing further advantages over prior art.

### Brief description

The detector (or arrays of such detectors) for measuring high fluxes and cumulative doses collected under ionizing irradiations by gamma rays, leptons and hadrons comprises a homogenous structure or a layered semi-insulating wide band-gap semiconductor material as well as a vertical mesa structure with both the electrical (ohmic/blocking, Schottky and junction type) and optical fiber probes.

### Brief description of drawings

Features of the invention believed to be novel and inventive are set forth with particularity in the appended claims. The invention itself, however, may be best understood by reference to the following detailed description of the invention, which describes exemplary embodiments, given in non-restrictive examples, of the invention, taken in conjunction with the accompanying drawings, in which:
Fig. 1 shows a) cross-section and b) planar top view of first embodiment of the ionizing radiation detector of the present invention;
Fig. 2 shows a) cross-section and b) planar top view of second embodiment of the ionizing radiation detector of the present invention;
Fig. 3 shows a) cross-section and b) planar top view of third and fourth embodiments of the ionizing radiation three-layered detector, containing thin layers of heavily doped p⁺ top and n⁺ bottom layers with either thin recombinant or rather thick drift layer in between p⁺ and n⁺ layers, of the present invention;
Fig. 4 shows a) cross-section and b) planar top view of fifth embodiment of the ionizing radiation detector of the present invention;
Fig. 5 shows current-voltage characteristics inherent for asymmetric mesa structures as shown in Fig. 1 and Fig. 2, varying either height of metal electrodes or depth of the V-groove.
Fig. 6 shows results of radiation beam profiling using the detectors according to embodiments as shown in Fig. 1 - Fig. 3. The cross-sections of the ionizing radiation detector of first, second, third, and fourth embodiments in the *x-y* plane are shown in **Fig. 1a****,** **Fig. 2a****,** and **Fig. 3a****,** and their planar top views in the *x-z* plane are shown in **Fig. 1b****,** **Fig. 2b****,** **Fig. 3b****,** respectively.

Preferred embodiments of the invention will be described herein below with reference to the drawings. Each figure contains the same numbering for the same or equivalent element.

### Detailed description

It should be understood that numerous specific details are presented in order to provide a complete and comprehensible description of the invention embodiment. However, the person skilled in art will understand that the embodiment examples do not limit the application of the invention which can be implemented without these specific instructions. Well-known methods, procedures and components have not been described in detail for the embodiment to avoid misleading. Furthermore, this description should not be considered to be constraining the invention to given embodiment examples but only as one of possible implementations of the invention. The scope of the invention is defined by the appended claims.

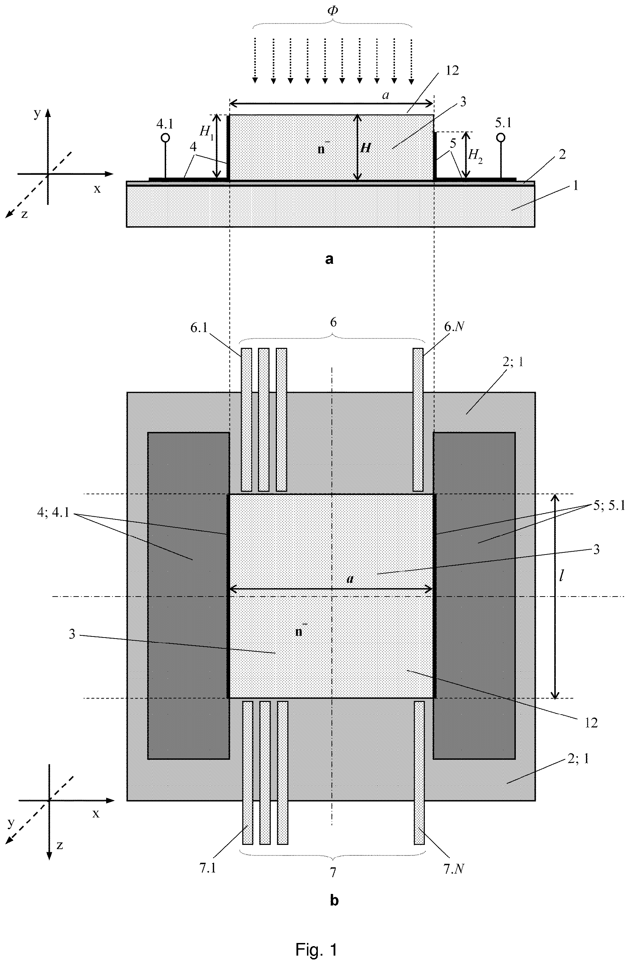

According to the invention first embodiment of the double response ionizing radiation detector is depicted in Fig. 1, where *x, y,* and *z* denote Cartesian coordinates. The detector comprises a plate-like substrate (**1**), made of a dielectric, for example, sapphire, which can have a rectangle shaped top surface (in *xz* plane), a buffer (matching) layer (**2**), formed on the top surface of the substrate (**1**). The crystal lattice parameters of the buffer layer (**2**) are close to structural parameters of the semiconductor mesa structure (**3**) material. On the top surface (in *xz* plane) of the buffer layer (**2**) a mesa structure (**3**) of height *H,* width *a* and length *l* is disposed. The mesa structure (3) is for example in a form of a strip having a rectangle shaped top surface, where *l* > *a,* the top surface of which is parallel to the top surface of the substrate (**1**). The top surface (*a·l* in *xz* plane) of the mesa structure (**3**) is oriented perpendicularly to the crystal axis *c* of the mesa structure (**3**) material. The mesa structure (**3**) is made of, for example, a weakly donor-type impurity doped *N*_{D} < 10¹⁴ cm⁻³ n⁻ -type conduction semiconductor or a homogeneous semi-insulating wide bandgap semiconductor with a forbidden energy gap of Δ*ε*_{g} > 3.5 eV, which ensures insensitivity to Solar spectrum light and low leakage current. The top surface (*a·l*) of the mesa structure (**3**) can serve as an irradiance window (**12**) through which detected flux ***Φ*** of ionizing radiation enters. Side areas *S*_{S(1; 2)} = *l·H*_{(1; 2)} of first and second side surfaces (in *yz* plane) of the mesa structure strip (**3**) are covered correspondingly with a first metal layer (**4**) and a second metal layer (**5**), forming two corresponding Schottky junctions with the mesa structure (**3**) crystal - the first and the second with the corresponding terminals - the first (**4.1**) and the second (**5.1**). The first side surface area S_{S 1} is completely coated with the first metal layer (**4**) covering an area from the upper surface of the buffer layer (**2**) to a height *H*₁ = *H*. The second side surface area S_{S 2} is covered by the second metal layer (**5**) in part - from the upper surface of the buffer layer (**2**) to the height *H*₂ < *H*. At the corresponding strip end-surfaces *S*_{e (1; 2)} = *a*·*H* of the mesa structure (**3**) and perpendicularly to them first ends of single-mode multiple optical fibers, comprising at least first optical fibers (**6.1, ..., 6.*N***) and second optical fibers (**7.1, ..., 7.*N***) of correspondingly at least first group (**6**) of fibers and second group (**7**) of fibers, are attached. Each fiber group (**6, 7**) contains *N* = 1; 2; 3; ... N optical fibers. The first ends of the optical fibers (**6.1, ..., 6.*N*; 7.1, ..., 7.*N***) of the corresponding groups (**6, 7**) are arranged perpendicularly to the strip-end-surfaces *S*_{e (1; 2)} and along to the diagonals of the rectangles (*a·H*) which represent the corresponding end-surfaces *S*_{e (1; 2)} = *a·H* of the rectangular strip, where these opposite diagonals are not parallel. The ends of the mesa structure (**3**) strip are cut perpendicularly, polished with optical smoothness and electrically insulated. Afterwards the first ends of the optical fibers (**6.1, ... 6.*N*; 7.1, ... 7.*N***) of corresponding groups (**6, 7**) are pressed, smoothed or welded, respectively, and the second ends of optical fibers are switched to optical signal recording multichannel devices.

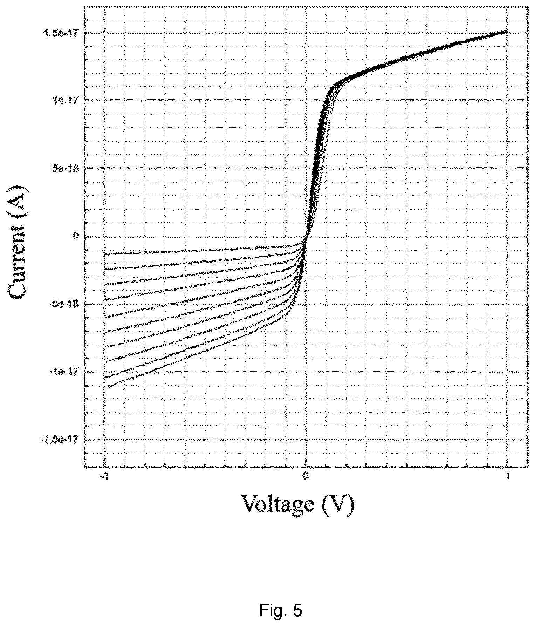

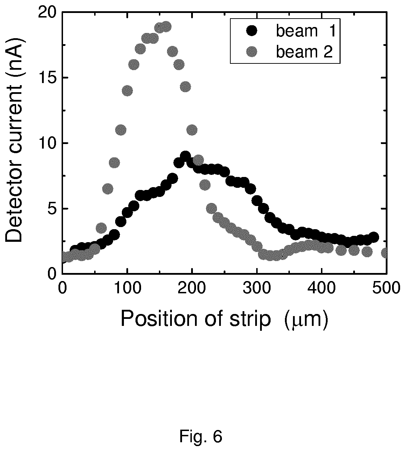

The ionizing radiation detector of the first embodiment operates as follows:
The reverse polarity voltage *U*_{R} of the external source *U* applied to the asymmetrical junction (the *U*_{R} value is chosen from the volt-ampere characteristics, Fig. 5) is connected between the detector electrical output terminals (**4.1, 5.1**) and the detected radiation flux ***Φ*** is fed to the detector mesa structure (**3**) through its top surface. The radiation flux ***Φ*** impinging into the volume of the mesa structure (**3**) generates secondary (non-equilibrium) electron (*n*) and hole (*p*) pairs (*np*) and the transients of the secondary hole and electron drift current or the collected charge are recorded by using relevant equipment. Synchronously a part of the secondary excess carrier *np* recombines through the luminescence channels. The luminescence intensity in the optical luminescence spectrum band is recorded by multiple optical fiber probes comprising said multiple optical fibers (**6.1, ... 6.*N*; 7.1, ... 7.*N***) using a multichannel analyzer of the luminescence spectrum and transients. By combining the synchronously recorded characteristics of the current/collected charge and the luminescence (the intensity distribution in the luminescence optical fiber probes, the amplitude values of the current components, etc.) and by modeling/fitting these characteristics recorded for the mesa structure (**3**) within fixed spectral range (stopping depths in the detector material, the drift length for holes and electrons, and the transmission time) the spectral composition of the incident radiation (based on the effective stopping range resolved by optical fiber probes comprising said multiple optical fibers (**6.1, ... 6.*N*; 7.1, ... 7.*N***) and situated on the diagonals of the rectangles (*a·H*), representing the end-surfaces of the detector mesa structure (3), and the number of secondary *np* pairs generated and estimated by analyzing the current variations in time *t*), and incident radiation flux (according to values of the current components) together with particle tracks are determined using developed algorithm. The radiation fluence (accumulated dose) is evaluated by the synchronous measurement of the charge collection efficiency changes (current circuit) and the variations of luminescence intensity during the radiation exposure, or by comparing the recorded electrical and optical parameters with calibration characteristics of these changes after irradiation. The evaluated fluence can be exploited for the in situ and simultaneous self-calibration of detector response values. Scanning of the cross-section (shape) of the incident radiation flux *Φ* (Fig. 6) is performed by moving the detector in perpendicular to the incident *Φ* beam plane.

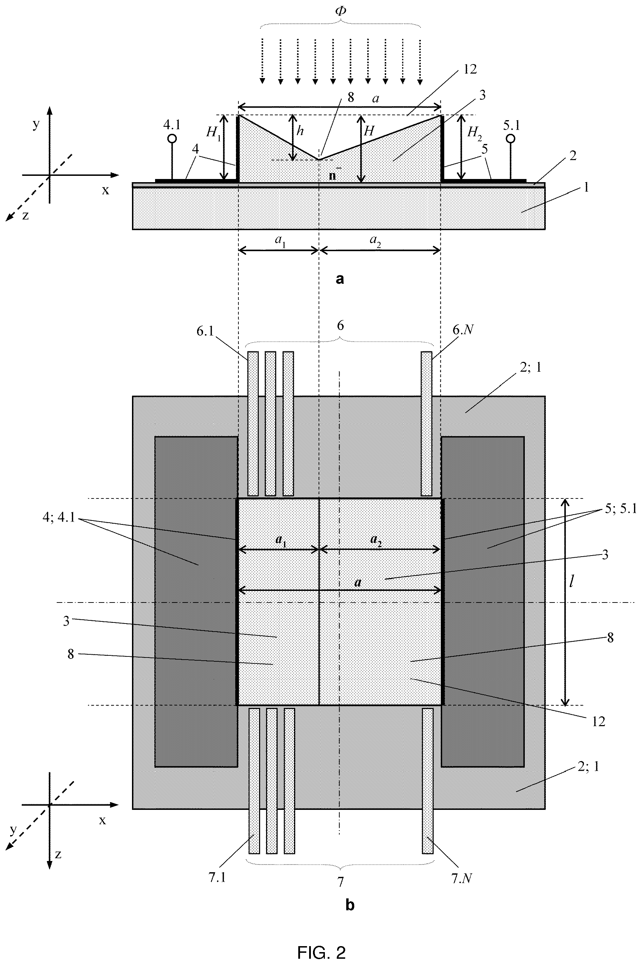

Second embodiment of the double response ionizing radiation detector is depicted in Fig. 2. It is made analogously to the construction of the first embodiment (Fig. 1), except the top surface (*a·l*) of the strip-shaped rectangle mesa structure (**3**) comprises a V-shaped groove (**8**) over the entire length *l* of the mesa structure. The groove (8) has width *d* ≈ *a*, and depth *h* from the top surface (in *xz* plane) of the mesa structure (**3**), where *h < H.* This condition allows to provide required strength of the electric field *E* under the V-shaped groove (**8**) of the mesa structure (**3**), and it simultaneously increases spatial resolution of the detector when external voltage source *U* is connected to the electrical terminals (**4.1, 5.1**). The areas *S*_{S(1; 2)} = *l·H*_{(1; 2)} of the first side surface Ss₁ and second side surface Sₛ₂ of the mesa structure (**3**) are entirely coated with a first metal layer (**4**) and a second metal layer (**5**), correspondingly, forming two ohmic contacts with the mesa structure (**3**), the first and the second, with the corresponding terminals, the first (**4.1**) and the second (**5.1**). The first ends of the optical fibers (**6.1, ... 6.*N*; 7.1, ... 7.*N***) of the relevant fiber groups (**6, 7**) are located along the entire width a of the mesa structure (**3**) in a straight line along the width a and perpendicularly to the corresponding end-surfaces *S*_{e(1; 2)} of the mesa structure (**3**). A spacing line is formed between the top surface (in xz plane) of the buffer layer (**2**) and the bottom of the V-shape groove (**8**). The apex of the V-shape groove (**8**) triangle is made at a distance *a*₁ from the first side-surface *S*_{S 1} of the mesa structure (**3**) with a metal layer (**4**) and *a*₂ from the second side-surface *S*_{S 2} of the strip (**2**) with a metal layer (**5**), where *a*₁ + *a*₂ = *a*.

The ionizing radiation detector of the second embodiment functions as follows:
The reverse polarity voltage *U*_{R} of the external source *U* is applied to the asymmetrical junction (the *U*_{R} value is chosen from the volt-ampere characteristics, Fig. 5) by connecting the external source *U* between the detector electrical terminals (**4.1, 5.1**). The detecting radiation flux ***Φ*** is fed to the detector mesa structure (**3**) through its top surface with the V-shaped groove (**8**) or a metal-free opening (**12**). The radiation flux ***Φ*** generates the secondary carrier pairs of density *N*ₙₚ within the mesa structure (**3**) volume, where the density *N*ₙₚ is related to the energy of the incident radiation *Φ* quantum (particle) *hv* (here *h* is Planck constant, *v* is the frequency of electromagnetic radiation), to the incident surface radiation flux *Φ* (quantum density *N*ᵥ crossing the detector volume per time unit) and to the nature of the radiation (in the case of pulsed radiation, *Φ*(*t*) is dependent on pulse duration Δ*t*; in the case steady-state radiation, *Φ*(*t*) = const collected per 1 second). In the case of steady-state radiation, a short-circuit current of the junction is measured in the external circuit, which is proportional to the radiation flux *Φ*. In the case of pulsed radiation, with low radiation flux, the transients of the displacement current, generated by secondary carrier drift, is recorded, while in the case of high-intensity radiation flux, the current transients of the charge extraction (the domain propagating through ambipolar diffusion) is recorded. Simultaneously, a portion of the secondary charge is recombined through non-radiative recombination centers in the mesa structure (**3**) material and through channels of luminescence (donor-acceptor (DA), band-D, A-band radiative recombination). Luminescence intensity of recombination radiation spectrum of the selected band is recorded by means of the optical fiber probes, (**6,7**) (by scanner) and is transferred to an integrating or expanded in time *t* multi-channel luminescence spectrum and transient analyzer. The characteristics of the synchronously recorded current and luminescence (distribution of intensity between the channels of the luminescence analyzer, the current components, current and luminescence pulse durations and delays, etc.), and modeling/fitting of these characteristics (obtained for a fixed range spectrum by selecting the radiation stopping depth in the detector mesa structure material, by evaluating the hole and electron drift lengths and transit times) according to the developed algorithms, are combined to evaluate the spectral composition of the incident radiation (according to the effective stopping range of the radiation and the number of secondary charge carrier pairs *np* generated), the flow (according to the current components) and the radiation (localization) tracks (according to the distribution of the luminescence intensity in optical fiber probes comprising multiple optical fibers (**6.1, ... 6.*N*; 7.1, ... 7.*N***)). The radiation fluence *F* (accumulated dose) is evaluated by the synchronous measurement of the time integrated electric response transients (charge collection efficiency) and by analysis of variations of the luminescence intensity (within chosen luminescence spectrum band) during the radiation exposure time, or by comparison the instantaneous (and post-irradiant) values of the registered electric (using laser radiation emulators) and the optical parameters with the calibration characteristics of these variations. The synchronous recording/control of a sequence of the electrical and optical response components in multichannel circuits allows to register both the solitary event of the incident high energy photons *hv* and the time/particle flux integrated processes. For the penetrative radiation with a low interaction cross-section and for a stopping length, significantly exceeding the mesa structure (**3**) height *H,* only the flow can be measured in the described manner, and a set of mesa structures of different heights is required for the estimation of the spectrum.

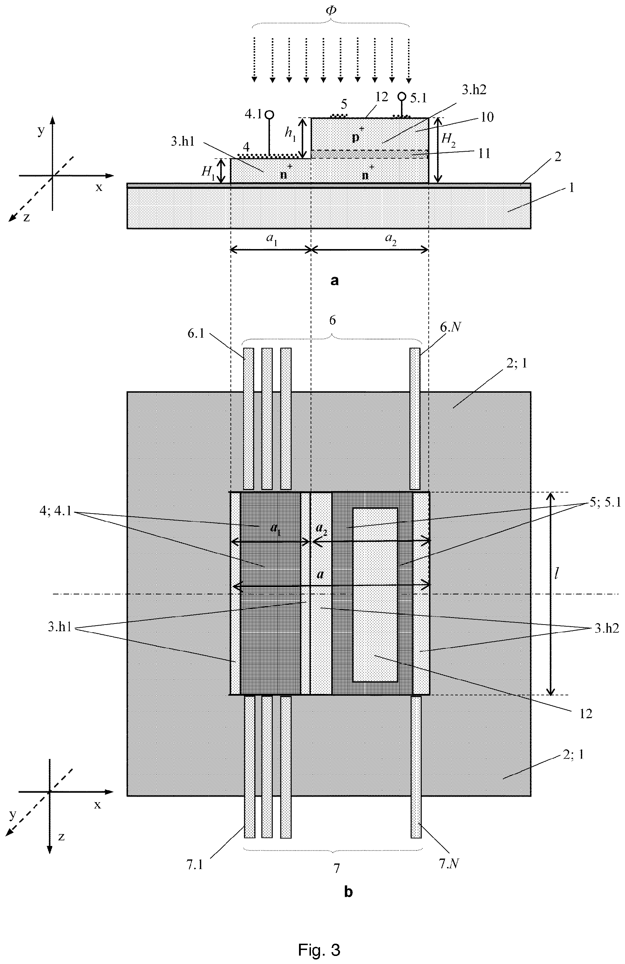

Third embodiment of the double response ionizing radiation detector is depicted in Fig. 3. The detector comprises a mesa structure (3) made in the shape of two steps (**3.h1, 3.h2)** with top surfaces parallel to the plane (in *xz* plane) of the top surface of the substrate (**1**). Each top surface of the steps **(3.h1, 3.h2)** comprise a corresponding parallel strip of metal layer (**4, 5**). The first step mesa structure (**3.h1**) is of the height *H*₁, the second step mesa structure (**3.h2**) is of the height *H*₂-*H*₁ so, that *H*₁ < *H*₂. The corresponding lengths of the steps **(3.h1, 3.h2)** are *I*₁ = *I*₂ = *I,* and the corresponding widths are *a*₁ ≈ *a*₂ < *I*. On the top surface of the second step (**3.h2**), by means of acceptor impurities *N*_{A 2} ≥ 10¹⁹ cm⁻³, a strongly doped p⁺-type conduction relatively thin layer (**10**) is formed, which contains an extremely thin quantum-well layer (QW) underneath, - a relatively narrow recombination layer (**11**) being an active optical emission region, for example, made of a super-lattice structure, and thereby forming a vertical p⁺-QW-n⁺-junction with the first step (**3.h1**) made of heavily doped n⁺ material, which is located within depth *h*₁ = *H*₂ - *H*₁ from the upper surface of the second step (**3.h2**). The top surface of the first step (**3.h1**) and the top surface of the second step (**3.h2**) are covered correspondingly with the first metal layer (**4**) and the second metal layer (**5**), forming corresponding ohmic contacts with mesa structures (**3.h1, 3.h2)** crystal with corresponding terminals - the first (**4.1**) and the second (**5.1**), where either thin layers of the first and second metal layers (**4, 5**) are transparent to the detected radiation or a metal-free opening (**12**), a window for the impinging radiation, is left with a metallization tape covering a perimeter of the top surface of the second step mesa structure (**3.h2**) . The first ends of the optical fibers (**6.1,** ...**6.*N***; **7.1, ...7.*N***) of the fiber groups (**6,7**) are in straight line along the entire width *a*₁+*a*₂ of the first step (**3.h1**) and perpendicularly to the corresponding end-surfaces *S*_{e h (1; 2)} of the steps.

The ionizing radiation detector of the third embodiment (Fig. 3) operates as follows:
The reverse voltage *U*_{R} of the external source *U* is applied to the p⁺-n⁺ junction between the electrical terminals (**4.1, 5.1**). The radiation flux ***Φ*** is fed into the mesa structure (**3, 3.h1, 3.h2)** of the detector through the top surface of the mesa structure (**3, 3.h1, 3.h2**) or the opening (**12**). The radiation flux ***Φ*** in the mesa structure (**3, 3.h1, 3.h2**) volume generates the secondary pairs of *np* (that are injected either in the thin upper p⁺-layer (**10**) of the mesa structure, within layer of the second step (**3.h2**), for the extremely stopped low energy photons/particles, or within the whole p⁺-QW-n⁺ structure volume (in the case of penetrative radiations). The radiation flux is evaluated by measuring and fitting the electrical and optical characteristics in the manner described for the first and the second embodiments. A cumulative fluence *F* collected during irradiation is registered by simultaneous measuring the electrical and optical response variations, which are fitted by employing the calibration curves, obtained using laser/particle accelerator emulators. The measured fluence values can be transmitted remotely by encoding digitally the optical signals (transmitted in free space or by a dedicated optical fiber channel) generated in the detector QW layer (**11**), when the polarity of external voltage *U*_{R} is replaced by the polarity of the forward polarity voltage *U*_{F}.

Fourth embodiment of the double response ionizing radiation detector is depicted in Fig. 3. The construction of the forth embodiment of the ionizing radiation detector is analogous to the construction of the third embodiment, except that the detector comprises a recombinant layer (**11**) formed as a charge drift layer *i* of the p⁺-i-n⁺ diode, formed by strongly doping a conduction bottom step (**3.h1**) with donor impurities *N*_{D} ≥ 10¹⁹ cm⁻³ region of n⁺-type (electronic) and strongly doping a conduction top step (**3.h2**) with the acceptor impurities *N*_{A} ≥ 10¹⁸ cm⁻³ region of p⁺-type (hole), wherein both said layers (3.h1, 3.h2) are separated from each other by a rather thick (*i*) layer (**11**) of a semi-insulating material. The first ends of the optical fibers (**6.1, ...6.*N*;7.1,...7.*N***) of the corresponding fiber group (**6, 7**) are located in a straight line along the widths a₁+a₂ of the bottom step (**3.h1**), perpendicularly to the end surfaces S_{e (1; 2)} of the corresponding strip, and along the n⁺- region at a height of ~ *H*₁/2 from the upper surface of the buffer layer (**2**).

The ionizing radiation detector of the fourth embodiment works as follows:
Between the electrical terminals (**4.1, 5.1**) the external reverse voltage *U*_{R} is applied to the p⁺-n⁺ layers of the mesa structure (**3, 3.h1, 3.h2**). The electrical signals generated within excess carrier drift *i* layer (due to the displacement or the charge extraction current components) are recorded together with optical responses when the detected radiation flux ***Φ*** is fed to the detector mesa structure (3, **3.h1, 3.h2**) surfaces where either thin layers of the first and second metal layers (**4, 5**) are transparent to the detected radiation or a metal-free opening (**12**), a window for the impinging radiation, is left with a metallization tape covering a perimeter of the top surface of the second step mesa structure (**3.h2**). The detector current and the optical signal intensity of the luminescence are simultaneously measured, and the radiation flux is evaluated by measuring and fitting the electrical and optical characteristics in the manner described above of the detector embodiment. The radiation fluence *F* (accumulated dose) is evaluated, using the developed algorithm, by comparing the recorded appropriate electrical and optical signals parameters with calibration characteristics of these variations. This detector construction and its mode of operation are designed to detect the small amounts of radiation fluxes *Φ* of penetrative radiations and of large fluences *F.*

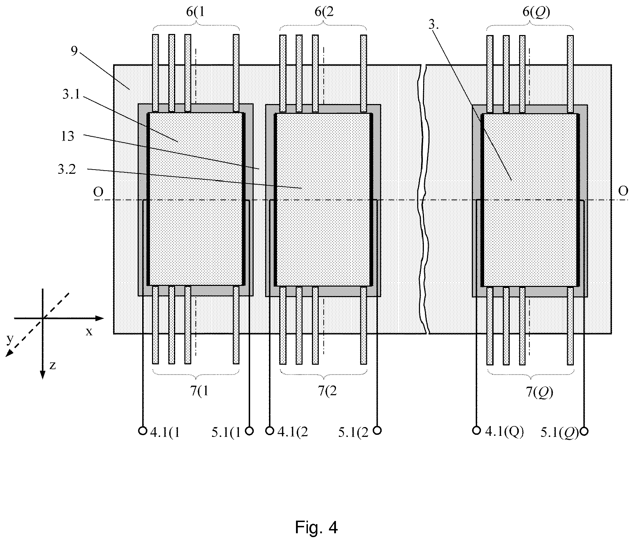

Fifth embodiment of the double response ionizing radiation detector is depicted in Fig. 4. The detectors of the first to the fourth embodiments (Fig. 1 - Fig. 3) form a matrix (Q), in which Q = 1; 2; 3; ...N detectors are mounted on the top surface (in *xz* plane) of a common substrate (**9**) symmetrically in one straight line (O-O) along the widths *a_{Q}* of the mesa structures (**3.1, ...3.M**) deployed with relevant interstices (**13**) between them with the corresponding Q pairs of electrical output terminals (**4.1, 5.1**) and 2·*Q·N* optical output terminals (**6, 7**).

The ionizing radiation detector of the fifth embodiment functions as follows:
The operation of each of the detectors forming the matrix (Q) is analogous to the processes and procedures described above. Signals of each of the detectors are synchronously scanned through a relevant multiplex system. This type of radiation detector is addressed for imaging of wide beams of the ionizing radiations and for recording of the large fluences. This type detector can be applied for imaging of the dynamics of the irradiation induced events within rather wide matrix by introducing the dedicated delay systems in order to register the respective time moments of the particle entrance and exit from the matrix detectors of the corresponding mesa structures (**3.1, ...3.*M***).

The double-response detector of the described embodiments of the invention uses optical and electrical response signals of which are recorded simultaneously by scanning tracks of high energy radiation particles ("elementary" such as γ-spectrum photons, neutrons, protons, pions, etc.) in the radiation-sensitive material of the detector, as well as the penetration (stopping) range, a current related to the density of secondary carrier pairs are measured for evaluation of energy and flux of the impinging radiation and radiation fluence is estimated from a decrease in the optical signal values, also serving as a benchmark for the self-calibration of electrical signals, due to the accumulated increase in radiation defect density.

Throughout the specification in all embodiments, the first ends of the first and second optical fibers (**6.1, ...6.*N*; 7.1, ...7.*N***) are attached the corresponding first end-surface *S*ₑ₁ and second end-surface *S*ₑ₂ of the mesa structure (**3**) perpendicularly to them.

Compared to analogues, the proposed ionizing radiation detector construction variants exhibit elevated spatial and temporal resolution, relatively small dark detector current, enhanced reliability due to improved radiation tolerance, insensitivity of the detector to the background radiation (of solar spectrum), while optical signal transmission paths are insensitive to electrical noises.

## Claims

1. Ionizing radiation detector comprising a substrate (**1, 9**), a radiation sensitive material and metal Schottky junctions (**4, 5**) and contact terminals (**4.1, 5.1**) for making ohmic contacts with said Schottky junctions wherein a buffer layer (**2**) is formed on the top surface of the substrate (**1, 9**) where a mesa structure (**3, 3.h1, 3.h2**) is formed on the top surface of the buffer layer (**2**) parallel to the top surface of the substrate (**1, 9**), where the top surface of the mesa structure (**3, 3.h1, 3.h2**) comprises an irradiance area (**12**) and the detector further comprises an optical fiber, **characterized in that** the substrate (**1, 9**) is made of a dielectric,
and **in that** the detector further comprises a first group (**6**) of fibers comprising a first set of single mode optical fibers (**6.1, ...6.*N***) and a second group (**7**) of fibers comprising a second set of single mode optical fibers (**7.1**,...**7**.***N***), where the first ends of said fibers (**6.1, ...6.*N*; 7.1,...7.*N***) are attached perpendicularly to the end-surfaces of the mesa structure (**3, 3.h1**) and the second ends of optical fibers are switched to optical signal recording multichannel devices and every fiber group consists of a set of ***N*** fibers.

2. Ionizing radiation detector according to claim **1 characterized in that** the mesa structure (**3**) comprises low-concentration donor-type impurity doped *N*_{D} ≤ 10¹³ cm⁻³ n⁻-type conduction or a homogeneous semi-insulating wide bandgap binary semiconductor crystal, the plane (*I*·*a*) of which is oriented perpendicularly to the crystal axis *c*, both side-surfaces *S*_{*S*(1; 2)} = *l·H_{(1,2)}* of the mesa structure (**3**) comprises a first metal layer strip (**4**) and a second metal layer strip (**5**) forming two corresponding Schottky junctions with the mesa structure **(3, 3.h1, 3.h2)** crystal, - the first output terminals (**4.1**) and the second output terminal (**5.1**), respectively, the first side surface of *S*_{*S* 1} is covered with the first metal layer strip (**4**) completely, overwhelming the area from the buffer layer to the height *H*₁ = *H*, and the second side surface *S*_{*S* 2} is covered with the second metal layer strip (**5**) in part, covering only an area from the buffer layer to the height *H*₂ < *H*, and the first ends of fibers (**6.1,** ...**6.*N***; **7.1,...7.*N***) of the fiber groups (**6, 7**) are located along the corresponding diagonals of the rectangles which represent the corresponding end-surfaces *S*_{*e*(1; 2)} = *a*·*H*, where these diagonals are not parallel.

3. Ionizing radiation detector according to claim **1 characterized in that** the top surface of the mesa structure (**3**) comprises a V-shape groove (**8**) having a width *d* ≈ *a* and a depth *h < H* along the entire length *l* of the mesa structure (**3**), and the V-shape groove (**8**) bottom is made at a distance *a*₁ from the first side surface Sₛ₁ of the strip with the first metal layer strip (**4**) and at a distance *a*₂ from the second side surface Sₛ₂ of the strip with the second metal layer strip (**5**), where *a*₁ + *a*₂ = *a,* the areas of the corresponding side surfaces of the mesa structure strip *S*_{S(1; 2)} = *l·H* are completely covered with said metal layers strips (**4, 5**) that make two corresponding ohmic contacts with the mesa structure (**3**) crystal, the first and the second, with corresponding first output terminal (**4.1**) and second output terminal (**5.1**), and the first ends of the optical fibers (**6.1, ...6.*N*; 7.1,...7.*N***) of the corresponding fiber groups *M*_{(1; 2)(1-*N*)} (**6, 7**) are located in a straight line along the width *a* of the corresponding strip end-surface *S*_{e(1; 2)}, below the depth *h* and relatively close to the buffer layer (**2**) boundary.

4. Ionizing radiation detector according to claim **1 characterized in that** the mesa structure (**3**) comprises two steps **(3.h1, 3.h2)** where top surface each of the steps (**3.h1, 3.h2**) form two corresponding parallel strips, where when the height of the first step is *H*₁, the second step is *H*₂ such, that *H*₁ < *H*₂, and have corresponding lengths *l*₁ = *l*₂ = *l* of the steps, where the respective widths of the steps **(3.h1, 3.h2)** are *a*₁ ≈ *a*₂ < *l*, where on the top surface of the second step (**3.h2**), by means of acceptor impurities *N*_{A 2} ≥ 10¹⁹ cm⁻³, a strongly doped p⁺-type conduction relatively thin layer (**10**) is formed, which contains an extremely thin quantum-well (QW) layer (**11**) underneath, - a relatively narrow recombination layer being an active optical emission region, for example, made of a super-lattice structure, and thereby forming a vertical p⁺-QW-n⁺-junction with the first step (**3.h1**) made of heavily doped n⁺ material, which is located within of the second step depth *h*₁ = *H*₂ - *H*₁ from the upper surface of the second step, the top surfaces of the steps are covered correspondingly with the first thin metal layer strip (**4**), and the second thin metal layer strip (**5**), which with the crystal form the corresponding ohmic contacts the first (**4**) and the second (**5**) with the appropriate output terminals (**4.1, 5.1**), where either the thin metal layer strips (**4, 5**) are transparent to the detecting radiation or a metal-free opening (**12**), a window for the impinging radiation, is left with a metallization tape covering a perimeter of the top surface only, and the first fiber ends of the corresponding optical fibers (**6.1, ...6.*N*; 7.1,...7.*N***) groups *M*_{(1; 2) (1-N)} (**6, 7**) are arranged at the end-surfaces S_{e2 (1; 2)} of the step strips close to the bottom of the second step (**3.h2**) in a straight line along the full mesa structure width *a*₁+*a*₂.

5. Ionizing radiation detector according to claim **4 characterized in that** the mesa structure region *V*₁ = (*a*₁ + *a*₂)·/·*H*₁ of the first step (**3.h1**) of height *H*₁ is heavily doped with donor impurities *N*_{D} ≥ 10¹⁹ cm⁻³ forming the region of n⁺-type (electronic) conduction, and the second step (**3.h2**) mesa structure region *V*₂ = *a₂·*/*·*(*H*₂ - *h*) is the strongly doped with the acceptor impurities *N*_{A} ≥ 10¹⁸ cm⁻³ forming the region of p⁺-type (hole) conduction material, and these *V*₁ and *V*₂ volumes are separated from each other by a rather thick (*i*) layer (**11**) of the semi-insulating material (of thickness *h*>> *H₁, H₂-h*), and this three-layered structure forms a vertical p⁺-*i*-n⁺ diode in which the recombinant layer is replaced by a charge drift layer *i* of the enhanced thickness *h,* and the first ends of the corresponding optical fibers (**6.1,** ...**6.*N***; **7.1,...7.*N***) groups *M*_{(1; 2) (1-*N*)} (**6**, **7**) are located in a straight line along width *a*_{(1; 2)} of the corresponding end-surface *S*_{e (1; 2)} of the corresponding step and along the n⁺-region at the height of ∼ *H*₁/2 from the upper surface of the buffer layer.

6. Ionizing radiation detector according to any one of claims **2-5, characterized in that** multiple detectors according to any one of claims 2-5 form a matrix (Q) in which the Q = 1; 2; 3; ...N detectors are mounted on the top surface of the co-substrate (**9**) symmetrically in one straight line along the widths *a_{Q}* of the mesa structures deployed with relevant interstices (**13**) between them with the corresponding Q pairs of electrical and 2·*Q·N* optical output terminals.

## Patentansprüche

1. Detektor ionisierender Strahlung, umfassend ein Substrat (1, 9), ein strahlungsempfindliches Material und metallische Schottky-Übergänge (4, 5) und Kontaktanschlüsse (4.1, 5.1) zum Herstellen ohmscher Kontakte mit den Schottky-Übergängen, wobei eine Pufferschicht (2) auf der oberen Oberfläche des Substrats (1, 9) gebildet ist, wobei eine Mesastruktur (3, 3.h1, 3.h2) auf der oberen Oberfläche der Pufferschicht (2) parallel zu der oberen Oberfläche des Substrats (1, 9) gebildet ist, wobei die obere Oberfläche der Mesastruktur (3, 3.h1, 3.h2) eine Einstrahlungszone (12) umfasst und der Detektor weiter eine optische Faser umfasst, **dadurch gekennzeichnet, dass** das Substrat (1, 9) aus einem Dielektrikum hergestellt ist,
und dadurch, dass der Detektor weiter eine erste Gruppe (6) von Fasern, umfassend einen ersten Satz von optischen Einzelmodus-Fasern (6.1, ... 6.*N*) und eine zweite Gruppe (7) von Fasern umfasst, umfassend einen zweiten Satz von optischen Einzelmodus-Fasern (7.1, ... 7.*N*), wobei die ersten Enden der Fasern (6.1, ... 6.*N*; 7.1, ... 7.*N*) senkrecht zu den Endoberflächen der Mesastruktur (3, 3.h1) befestigt sind und die zweiten Enden der optischen Fasern zu optischen signalaufzeichnenden Multikanalvorrichtungen getauscht sind und jede Fasergruppe aus einem Satz von *N* Fasern besteht.

2. Detektor ionisierender Strahlung nach Anspruch 1, **dadurch gekennzeichnet, dass** die Mesastruktur (3) niedrige Konzentration donorartiger Verunreinigung *N*_{D} ≤ 10¹³ cm⁻³ dotierte n⁻-Art von Leitung umfasst oder einen homogenen halbisolierenden binären Halbleiterkristall breiter Bandlücke, von dem die Ebene (*l* · *a*) senkrecht zu der Kristallachse *c* orientiert ist, beide Seitenoberflächen *Ss* _{(1; 2)} = *l* · *H_{(1,2)}* der Mesastruktur (3) einen ersten metallischen Schichtstreifen (4) und einen zweiten metallischen Schichtstreifen (5) umfasst, die zwei entsprechende Schottky-Übergänge mit dem Kristall der Mesastruktur (3, 3.h1, 3.h2) bilden, - wobei jeweils die ersten Ausgabeanschlüsse (4.1) und der zweite Ausgabeanschluss (5.1), die erste Seitenoberfläche von *S*_{*s* 1} mit dem ersten metallischen Schichtstreifen (4) vollständig bedeckt ist, die Zone aus der Pufferschicht zu der Höhe *H₁* = *H* überragend, und die zweite Seitenoberfläche *S*_{*S*2} teilweise mit dem zweiten metallischen Schichtstreifen (5) bedeckt ist, ausschließlich eine Zone aus der Pufferschicht zu der Höhe *H*₂ < *H* bedeckend, und die ersten Enden von Fasern (6.1, ... 6.*N*; 7.1, ... 7.*N*) der ersten Gruppen (6, 7) sich entlang der entsprechenden Diagonalen der Rechtecke befinden, die die entsprechenden Endoberflächen *S*_{*e*(1; 2)} = *a* · *H* repräsentieren, wobei diese Diagonalen nicht parallel sind.

3. Detektor ionisierender Strahlung nach Anspruch 1, **dadurch gekennzeichnet, dass** die obere Oberfläche der Mesastruktur (3) eine V-förmige Rille (8) mit einer Breite *d* ≈ *a* und einer Tiefe *h < H* entlang der gesamten Länge *l* der Mesastruktur (3) umfasst, und der Boden der V-förmige Rille (8) in einem Abstand *a₁* von der ersten Seitenoberfläche Sₛ₁ des Streifens mit dem ersten metallischen Schichtstreifen (4) und in einem Abstand *a₂* von der zweiten Seitenoberfläche Sₛ₂ des Streifens mit dem zweiten metallischen Schichtstreifen (5) hergestellt ist, wobei *a₁* + *a*₂ = *a*, wobei die Zonen der entsprechenden Seitenoberflächen des Mesastrukturstreifens S_{S(1; 2)} = *l* · *H* vollständig mit den metallischen Schichtstreifen (4, 5) bedeckt sind, die zwei entsprechende ohmsche Kontakte mit dem Kristall der Mesastruktur (3), den ersten und den zweiten, mit entsprechendem ersten Ausgabeanschluss(4.1) und zweiten Ausgabeanschluss (5.1) herstellen, und sich die ersten Enden der optischen Fasern (6.1, ... 6.*N*; 7.1, ... 7.*N*) der entsprechenden Fasergruppen *M*_{(1; 2)(1-*N*)} (6, 7) in einer geraden Linie entlang der Breite a der entsprechenden Streifenendoberfläche S_{e(1; 2)}, unterhalb der Tiefe h und relativ nahe an der Pufferschicht (2)-Grenzlinie, befinden.

4. Detektor ionisierender Strahlung nach Anspruch 1, **dadurch gekennzeichnet, dass** die Mesastruktur (3) zwei Stufen (3.h1, 3.h2) umfasst, wobei die obere Oberfläche jeder der Stufen (3.h1, 3.h2) zwei entsprechende parallele Streifen bilden, wobei, wenn die Höhe der ersten Stufe *H*₁ ist, die zweite Stufe *H*₂ so ist, dass *H*₁ < *H*₂, und entsprechende Längen *l*₁ = *l*₂ = *l* der Stufen aufweisen, wobei die jeweiligen Breiten der Stufen (3.h1, 3.h2) *a*₁ ≈ *a*₂ *< l* sind, wobei auf der oberen Oberfläche der zweiten Stufe (3.h2) mittels Akzeptorverunreinigungen N_{A 2} ≥ 10¹⁹ cm⁻³ ein stark dotierter Leiter der p⁺-Art relativ dünner Schicht (10) gebildet ist, die eine extrem dünne Quantentopf(QW)-Struktur (11) darunter bildet, - eine relativ schmale Rekombinationsschicht ein aktiver optischer Emissionsbereich ist, zum Beispiel aus einer Supergitterstruktur hergestellt und dadurch einen aus schwer dotiertem n⁺-Material, das sich innerhalb der zweiten Stufentiefe *h*₁ = *H*₂ - *H*₁ von der oberen Oberfläche der zweiten Stufe befindet, hergestellten vertikalen p⁺-QW-n⁺-Übergang mit der ersten Stufe (3.h1) bildend, wobei die oberen Oberflächen der Stufen entsprechend mit dem ersten dünnen metallischen Schichtstreifen (4) bedeckt sind, und der zweite dünne metallische Schichtstreifen (5), mit dem der Kristall die entsprechenden ohmschen Kontakte, den ersten (4) und den zweiten (5), mit den angemessenen Ausgabeanschlüssen (4.1, 5.1) bilden, wobei jeder der dünnen metallischen Schichtstreifen (4, 5) der detektierenden Strahlung gegenüber transparent sind oder eine metallfreie Öffnung (12), ein Fenster für die aufprallende Strahlung, mit einem Metallisierungsband, das ausschließlich einen Umfang der oberen Oberfläche bedeckt, belassen wird, und die ersten Faserenden der entsprechenden optischen Fasern (6.1, ... 6.*N*, 7.1, ... 7.*N*)-Gruppen *M*_{(1; 2) (1-N)} (6, 7) an den Endoberflächen S_{e2 (1; 2)} der Stufenstreifen nahe an dem Boden der zweiten Stufe (3.h2) in einer geraden Linie entlang der ganzen Mesastrukturbreite *a*₁+*a*₂ angeordnet sind.

5. Detektor ionisierender Strahlung nach Anspruch 4, **dadurch gekennzeichnet, dass** der Mesastrukturbereich *V*₁ = (*a*₁ + *a₂*) · *l ·H*₁ der ersten Stufe (3.h1) von Höhe *H₁* schwer mit Donorverunreinigungen *N*_{D} ≥ 10¹⁹ cm⁻³ dotiert ist, den Bereich von (elektronischer) Leitung der n⁺-Art bildend, und die zweite Stufe (3.h2) Mesastrukturbereich *V*₂ = *a*₂ · *l* · (*H*₂ - *h*) der stark mit den Akzeptorverunreinigungen *N*_{A} ≥ 10¹⁸ cm⁻³ dotierte ist, den Bereich von (Loch) Leitungsmaterial der p⁺-Art bildend, und die *V*₁- und *V*₂-Volumen voneinander durch eine eher dicke (*i*)-Schicht (11) von dem halbisolierenden Material (der Dicke *h*>> *H*₁, *H*₂-*h*) getrennt sind, und diese dreischichtige Struktur eine vertikale p⁺-*i*-n⁺-Diode bildet, in der die rekombinante Schicht durch eine Ladungsdriftschicht *i* der verstärkten Dicke *h* ersetzt ist, und die ersten Enden der entsprechenden optischen Fasern (6.1, ... 6.*N*; 7.1, ... 7.*N*) Gruppen *M*_{(1; 2) (1-*N*)} (6, 7) sich in einer geraden Linie entlang Breite *a*_{(1; 2)} der entsprechenden Endoberfläche S_{e (1; 2)} der entsprechenden Stufe und entlang des n⁺-Bereichs an der Höhe von ∼ *H*₁/2 von der oberen Oberfläche der Pufferschicht befinden.

6. Detektor ionisierender Strahlung nach einem der Ansprüche 2-5, **dadurch gekennzeichnet, dass** mehrere Detektoren nach einem der Ansprüche 2-5 eine Matrix (Q) bilden, in der Q = 1; 2; 3;...N Detektoren auf der oberen Oberfläche des Co-Substrats (9) symmetrisch in einer geraden Linie entlang der Breiten *a_{Q}* der Mesastrukturen montiert sind, die mit relevanten Zwischenräumen (13) zwischen ihnen mit den entsprechenden *Q* Paaren von elektrischen und 2 *Q N* optischen Ausgabeanschlüssen eingesetzt sind.

## Revendications

1. Détecteur de rayonnement ionisant comprenant un substrat (1, 9), un matériau sensible à un rayonnement et des jonctions Schottky métalliques (4, 5) et des bornes de contact (4.1, 5.1) pour réaliser des contacts ohmiques avec lesdites jonctions Schottky, dans lequel une couche tampon (2) est formée sur la surface supérieure du substrat (1, 9) où une structure mesa (3, 3.h1, 3.h2) est formée sur la surface supérieure de la couche tampon (2) parallèlement à la surface supérieure du substrat (1, 9), où la surface supérieure de la structure mesa (3, 3.h1, 3.h2) comprend une zone de rayonnement (12) et le détecteur comprend en outre une fibre optique, **caractérisé en ce que** le substrat (1, 9) est constitué d'un diélectrique,
et **en ce que** le détecteur comprend en outre un premier groupe (6) de fibres comprenant un premier ensemble de fibres optiques monomodes (6.1, ..., 6.*N*) et un second groupe (7) de fibres comprenant un second ensemble de fibres optiques monomodes (7.1, ..., 7.*N*), où les premières extrémités desdites fibres (6.1, ..., 6.*N* ; 7.1, ..., 7.*N*) sont fixées perpendiculairement aux surfaces d'extrémité de la structure mesa (3, 3.h1) et les secondes extrémités des fibres optiques sont commutées vers des dispositifs multicanaux d'enregistrement de signal optique et chaque groupe de fibres se compose d'un ensemble de *N* fibres.

2. Détecteur de rayonnement ionisant selon la revendication 1, **caractérisé en ce que** la structure mesa (3) comprend une conduction de type n⁻ dopée avec des impuretés de type de donneur *N*D ≤ 10¹³ cm⁻³ à faible concentration ou un cristal semi-conducteur binaire à large bande interdite semi-isolante homogène, dont le plan (*I*·*a*) est orienté perpendiculairement à l'axe du cristal c, les deux surfaces latérales SS(1 ; 2) = *l·H(1,2)* de la structure mesa (3) comprend une première bande de couche métallique (4) et une seconde bande de couche métallique (5) formant deux jonctions Schottky correspondantes avec le cristal à structure mesa (3, 3.h1, 3.h2), les premières bornes de sortie (4.1) et les secondes bornes de sortie (5.1) respectivement, la première surface latérale de *S*S1 est complètement recouverte de la première bande de couche métallique (4), écrasant la zone allant de la couche tampon à la hauteur *H*1 = *H*, et la seconde surface latérale de *S*S2 est en partie recouverte de la seconde bande de couche métallique (5), recouvrant seulement une zone allant de la couche tampon à la hauteur *H*2 < *H*, et les premières extrémités des fibres (6.1, ..., 6.*N*; 7.1, ..., 7.*N*) des groupes de fibres (6, 7) sont situées le long des diagonales correspondantes des rectangles qui représentent les surfaces d'extrémités correspondantes *S*e(1 ; 2) = *a·H*, où ces diagonales ne sont pas parallèles.

3. Détecteur de rayonnement ionisant selon la revendication 1, **caractérisé en ce que** la surface supérieure de la structure mesa (3) comprend une rainure en forme de V (8) ayant une largeur *d* ≈ *a* et une profondeur *h* < *H* le long de toute la longueur *l* de la structure mesa (3) et le fond de la rainure en forme de V (8) est réalisé à une distance *a1* de la première surface latérale Ss1 de la bande avec la première bande de couche métallique (4) et à une distance a2 de la de la seconde surface latérale Ss2 de la bande avec la seconde bande de couche métallique (5), où *a1* + *a2* = *a,* les aires des surfaces latérales correspondantes de la bande de structure mesa *S*s(1 ; 2) = *l*·*H* sont complètement recouvertes desdites bandes de couches métalliques (4, 5) qui réalisent deux contacts ohmiques correspondants avec le cristal de la structure mesa (3), le premier et le second, avec la première borne de sortie (4.1) et la seconde borne de sortie (5.1) correspondantes, et les premières extrémités des fibres optiques (6.1, ..., 6.*N*; 7.1, ..., 7.*N*) des groupes de fibres correspondants M(1 ; 2)(1 - N) (6, 7) sont situées sur une ligne droite le long de la largeur a de la surface d'extrémité de bande correspondante *S*e(1 ; 2) en dessous de la profondeur *h* et relativement près de la limite de la couche tampon (2).

4. Détecteur de rayonnement ionisant selon la revendication 1, **caractérisé en ce que** la structure mesa (3) comprend deux surépaisseurs (3.h1, 3.h2) où la surface supérieure de chacune des surépaisseurs (3.h1, 3.h2) forme deux bandes parallèles correspondantes, où, lorsque la hauteur de la première surépaisseur est *H*1, de la seconde surépaisseur est *H*2 de telle sorte que *H*1 < *H*2 et présentent des longueurs correspondantes *l*1 = *l*2 = *l* des surépaisseurs, où les largeurs respectives des surépaisseurs (3.h1, 3.h2) sont *a*1 ≈ *a*2 < *l*, où, sur la surface supérieure de la seconde surépaisseur (3.h2), au moyen des impuretés d'accepteur *N*A2 ≥ 10¹⁹ cm⁻³, une couche relativement mince de conduction de type p⁺ fortement dopée (10) est formée, qui contient une couche de puits quantique (QW) extrêmement mince (11) en dessous, une couche de recombinaison relativement étroite étant une région d'émission optique active, par exemple, constituée d'une structure de super réseau, et formant, de ce fait, une jonction verticale p⁺-QW-n⁺ avec la première surépaisseur (3.h1) constituée d'un matériau n⁺ lourdement dopé, qui est situé dans la profondeur de la seconde surépaisseur *h*1 = *H*2. - *H*1 par rapport à la surface supérieure de la seconde surépaisseur, les surfaces supérieures des surépaisseurs sont recouvertes de manière correspondante de la première mince bande de couche métallique (4) et de la seconde mince bande de couche métallique (5), qui, avec le cristal, forment les contacts ohmiques correspondants, le premier (4) et le second (5), avec les bornes de sortie appropriées (4.1, 5.1), où soit les minces bandes de couche métallique (4, 5) sont transparentes au rayonnement de détection, soit une ouverture dépourvue de métal (12), une fenêtre pour le rayonnement incident, est laissée avec une bande de métallisation recouvrant seulement un périmètre de la surface supérieure et les premières extrémités de fibre des groupes de fibres optiques correspondantes (6.1, ..., 6.*N* ; 7.1, ..., 7.*N*) *M*(1 ; 2)(1 - N) (6, 7) sont agencées au niveau des surfaces d'extrémité Se2(1 ; 2) des bandes de surépaisseur proches du fond de la seconde surépaisseur (3.h2) sur une ligne droite le long de toute la largeur de la structure mesa *a*1 + *a*2.

5. Détecteur de rayonnement ionisant selon la revendication 4, **caractérisé en ce que** la région de structure mesa *V*1 = (*a1* + a2)·/·*H*1 de la première surépaisseur (3.h1) de hauteur *H*1 est lourdement dopée avec des impuretés de donneur *N*D ≥ 10¹ cm⁻³ formant la région de conduction (électronique) de type n+ et la région de structure mesa de la première surépaisseur (3.h2) *V2* = *a*2*·l*·(*H*2 - *h)* est fortement dopée avec les impuretés d'accepteur *N*A ≥ 10¹⁸ cm⁻³ formant la région de matériau de conduction (trou) de type p⁺ et ces volumes *V*1 et *V*2 sont séparés l'un de l'autre par une couche plutôt épaisse (*i*) (11) du matériau semi-isolant (d'épaisseur *h* >> *H*1, *H2* - *h*) et cette structure à trois couches forme une diode verticale p⁺-*i*-n⁺ dans laquelle la couche recombinante est remplacée par une couche de décalage de charge ide l'épaisseur améliorée *h,* et les premières extrémités des groupes de fibres optiques correspondantes (6.1, ..., 6.*N* ; 7.1, ..., 7.*N*) M(1 ; 2) (1 - N) (6, 7) sont situées sur une ligne droite le long de la largeur *a*(1 ; 2) de la surface d'extrémité correspondante *S*e(1 ; 2) de la surépaisseur correspondante et le long de la région n⁺ à la hauteur de ∼ *H*1/2 par rapport à la surface supérieure de la couche tampon.

6. Détecteur de rayonnement ionisant selon l'une quelconque des revendications 2 à 5, **caractérisé en ce que** de multiples détecteur selon l'une quelconque des revendications 2 à 5 forment une matrice (Q) dans laquelle les Q = 1 ; 2 ; 3 ; ... N détecteurs sont montés sur la surface supérieure du cosubstrat (9) de manière symétrique sur une seule ligne droite le long des largeurs *aQ* des structures mesa déployées avec des interstices appropriés (13) entre elles avec les *Q* paires correspondantes de bornes de sortie électrique et 2·*Q·N* bornes de sortie optique.
